(19) Europäisches Patentamt
European Patent Office
Office européen des brevets

(11) **EP 3 926 768 B1**

(12) **EUROPEAN PATENT SPECIFICATION**

(45) Date of publication and mention
of the grant of the patent:
**14.05.2025 Bulletin 2025/20**

(21) Application number: **20756057.4**

(22) Date of filing: **06.02.2020**

(51) International Patent Classification (IPC):
**H01S 5/022** *(2021.01)* **H01S 5/042** *(2006.01)*

(52) Cooperative Patent Classification (CPC):
**H01S 5/04252; H01S 5/22;** H01S 5/0014;
H01S 5/0237; H01S 5/02476; H01S 5/2068;
H01S 5/305; H01S 5/3054; H01S 5/3211;
H01S 5/34313; H01S 2301/176

(86) International application number:
**PCT/JP2020/004604**

(87) International publication number:
**WO 2020/166483 (20.08.2020 Gazette 2020/34)**

(54) **ELECTRODE, SEMICONDUCTOR LASER ELEMENT, AND CHIP ON SUBMOUNT**

ELEKTRODE, HALBLEITERLASERELEMENT UND CHIP AUF SUBMOUNT

ÉLECTRODE, ÉLÉMENT LASER À SEMI-CONDUCTEUR ET PUCE SUR EMBASE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **13.02.2019 JP 2019023288**

(43) Date of publication of application:
**22.12.2021 Bulletin 2021/51**

(73) Proprietor: **Furukawa Electric Co., Ltd.**
**Tokyo 100-8322 (JP)**

(72) Inventors:
• **UMENO, Kazuyuki**
  **Tokyo 100-8322 (JP)**
• **OHKI, Yutaka**
  **Tokyo 100-8322 (JP)**

(74) Representative: **SSM Sandmair**
**Patentanwälte Rechtsanwalt**
**Partnerschaft mbB**
**Joseph-Wild-Straße 20**
**81829 München (DE)**

(56) References cited:
WO-A1-2014/018599    WO-A1-2018/203466
JP-A- 2006 156 639    JP-A- 2013 062 315
JP-A- 2013 125 886    JP-A- 2018 037 601
US-A1- 2004 013 147    US-A1- 2005 213 628

**Description**

Field

The present invention relates to an electrode, a semiconductor laser element, and a chip-on-submount.

Background

Conventionally, semiconductor laser elements have found their applications in industrial lasers used for machining, for example. Because the industrial lasers are required to be high power and highly efficient compared with lasers used for optical communications, but are not required to have a capability for long distance transportation, multi-mode lasers specifically designed for high power output have been used as the industrial lasers. In such a multi-mode laser, the high power output is achieved by increasing the horizontal width of the laser waveguide, and accommodating a plurality of horizontal lateral modes inside the waveguide. As a p-side electrode provided on the p-type semiconductor layer of a high-power semiconductor laser element or the like, a Ti/Pt/Au laminate structure, in which layers of titanium (Ti), platinum (Pt), and gold (Au) are sequentially laid, has been known (see Patent Literature 1).

Citation List

Patent Literature

Patent Literature 1: Japanese Patent No. 3314616 Further prior art concerning p-side electrodes comprising specific thickness Ti-Pt-Au layers can be found in JP2006156639, US2013156060 and in intermediate document (relevant for Art. 54(3) EPC) EP3872939. Summary

Technical Problem

Because wall plug efficiency (WPE), which is defined as a ratio of a final optical power with respect to an input power (forward current $\times$ forward voltage), is required to be high in a high power semiconductor laser element, there have been demands for technologies for improving the WPR of the semiconductor laser element.
The present invention is made in light of the above and an object is to provide an electrode, a semiconductor laser element, and a chip-on-submount in which the WPE of a semiconductor can be improved.

Solution to Problem

To resolve the above problem and attain the object, an electrode according to the present invention includes a Ti layer and a Pt layer that are sequentially laid on a surface of a p-type semiconductor layer.
Further, a thermal impedance per unit area of a contact portion that is in contact with the surface of the p-type semiconductor layer is equal to or smaller than $1.2 \times 10^4$ K/W·m$^2$.
In the electrode according to an embodiment of the present invention, as defined in the appended claims, it is possible to have a desired thermal impedance per unit area of the contact portion that is in contact with the surface of the p-type semiconductor layer even when there is a manufacturing deviation in forming the Ti layer.
In the electrode according to the present invention, a film thickness of the Ti layer is equal to or more than 5 nm and equal to or smaller than 35 nm, and the film thickness of the Pt layer is equal to or more than 30 nm. With this configuration, it is possible to maintain the function as a barrier metal of the Ti layer against the Pt layer on the upper layer side.
In the electrode according to an embodiment of the present invention, a sum of a film thickness of the Ti layer and a film thickness of the Pt layer is equal to or smaller than 70 nm. With this configuration, it is possible to reduce the thermal resistance of the electrode.
In the electrode according to the present invention, a film thickness of the Pt layer is equal to or more than 30 nm. With this configuration, it is possible to control the diffusion of the metal material of the upper layer of the Pt layer to the lower layer.
In the electrode according to an embodiment of the present invention, a film thickness of the Pt layer is equal to or more than 0.7 times and equal to or smaller than 1 time a film thickness of the Ti layer. With this configuration, even when after the electrode is formed on the p-type semiconductor layer, a thermal processing in a range from 300 degrees Celsius to 450 degrees Celsius is performed, the formation of TiPt$_3$ due to alloying of the Ti layer and the Pt layer can be suppressed, and the reduction of the thermal conductivity in the electrode can be suppressed.
In the electrode according to an embodiment of the present invention, an Au layer is further laid on top of the Pt layer.

A semiconductor laser element according to an embodiment of the present invention includes an n-type semiconductor layer, an active layer, and a p-type semiconductor layer that are sequentially laid on top of another, the semiconductor laser element being able to output a laser beam. Further, the above electrode is provided on a surface of the p-type semiconductor layer.

In the semiconductor laser element according to an embodiment of the present invention, the p-type semiconductor layer is a group III-V compound semiconductor layer.

In the semiconductor laser element according to an embodiment of the present invention, the p-type semiconductor layer is a GaAs layer.

In the semiconductor laser element according to an embodiment of the present invention, a concentration of a p-type impurity in the p-type semiconductor layer is equal to or higher than $1\times10^{19}$ cm$^{-3}$.

In the semiconductor laser element according to an embodiment of the present invention, a driving method used for the semiconductor laser element is a continuous-wave operation.

In the semiconductor laser element according to an embodiment of the present invention, a stripe width is equal to or greater than 100 $\mu$m.

A chip-on-mount according to an embodiment of the present invention includes: the above semiconductor laser element; and a mount on which the semiconductor laser element is fixed in a junction-down configuration. Advantageous Effects of Invention

With the electrode, the semiconductor laser element, and the chip-on-submount according to the present invention, the WPE of a semiconductor can be improved.

Brief Description of Drawings

FIG. 1 is a cross-sectional view schematically illustrating a structure of a semiconductor laser element according to one embodiment of the present invention.
FIG. 2 is a Pt-Ti phase diagram illustrating phases of formation of a Pt and Ti alloy.
FIG. 3 is a schematic cross-sectional view of a chip-on-submount according to the one embodiment of the present invention.
FIG. 4 is a graph illustrating relative values of optical power of the semiconductor laser element according to an example of the one embodiment of the present invention and a semiconductor laser element in a comparative example using a conventional technology.
FIG. 5 is a graph illustrating relative values of forward voltage of the semiconductor laser elements in the example of the one embodiment of the present invention and the comparative example using the conventional technology.
FIG. 6 is a graph illustrating relative values of WPE of the semiconductor laser elements in the example of the one embodiment of the present invention and the comparative example using the conventional technology.

Description of Embodiments

An embodiment of the present invention will now be explained with reference to some drawings. In all of the drawings in the embodiment, the same or corresponding parts are given the same reference signs. Furthermore, the embodiment explained below is not intended to limit the scope of the present invention in any way.

To start with, to facilitate understanding of the present invention, diligent development efforts made by the inventors of the present invention in order to improve the WPE of a semiconductor laser element will be explained. To begin with, the inventors of the present invention made some research on technologies for improving the WPE of a GaAs-based high power multi-mode semiconductor laser element. As a general structure of high power multi-mode semiconductor laser elements, an n-side electrode is disposed on the rear surface of a substrate, and a p-side electrode is disposed on the front surface of a semiconductor laminated film, and is die-bonded in a junction-down configuration to a submount. Therefore, the p-side electrode is located in a heat radiation path of the semiconductor laser element.

Therefore, the inventors of the present invention focused on operations of the semiconductor laser element in junction-down configuration, and considered how the material constituting the p-side electrode, which radiates heat, contributes to the thermal impedance. As the p-side electrode, a Ti/Pt/Au laminated film is generally used. Because the Ti layer that is a first layer of the p-side electrode is a layer that is brought into contact with the p-type semiconductor layer, this layer serves as a layer for exerting adhesiveness to, and maintaining the contact resistance with the p-type semiconductor layer low. The Pt layer that is a second layer has a greater work function than that of the Ti layer, and has a function for achieving a low contact resistance ratio with respect to the p-type semiconductor layer. The Pt layer that is the second layer and the Au layer that is a third layer react with gallium arsenide (GaAs) that is used as a p-type semiconductor layer. Therefore, the Ti layer that is the first layer functions as a barrier metal for suppressing diffusions of the Pt layer that is the second layer into the GaAs layer, and the Pt layer that is the second layer functions as a barrier metal for suppressing diffusions of the Au layer that is the third layer into the GaAs layer. In Table 1, the thermal conductivities (W/m•K) and the electrical resistivities (nΩ•m) of the metals used for the p-side electrode having a structure described above in the room temperature are indicated.

Table 1

| Material Properties | Thermal Conductivity (W/m•K) | Electrical Resistivity (nΩ•m) |
|---|---|---|
| Ti | 21.9 | 420 |
| Pt | 71.6 | 105 |
| Au | 318 | 22.14 |

Conventionally, because the thickness of the electrode is extremely small compared with that of the semiconductor layer or the submount, the thermal conductivity and the thermal impedance of the materials constituting the electrode has not given much consideration. Furthermore, because the p-side electrode of the semiconductor laser element is used to apply a current that is to flow along the active layer, it has been believed that a reduction in the thickness of the Ti layer or the Pt layer serving as barrier metals is very much likely to invite a deterioration of reliability.

Therefore, designs of the electrode have only been examined with a focus on the electrical resistance of the p-side electrode.

To address this issue, based on Table 1, the inventors of the present invention performed various experiments by focusing on the thermal conductivities of the Ti layer and the Pt layer, which have thermal conductivities lower than that of the Au layer by one order of magnitude or so, while using thin Ti/Pt layers, specifically, those having a thickness of several ten nanometers. The thermal impedance $R_T$ of the p-side electrode was calculated based on the following Equation (1). $\Sigma_{n=1}^3$ means figuring out the sum of n = 1, 2, 3.

$$R_T \;=\; \Sigma_{n=1}^3 d_n / (k_n \bullet w_c \bullet L_c) \qquad\qquad (1)$$

n denotes the numbers assigned to the layers, that is, the first layer, the second layer, and the third layer, respectively, constituting a p-side electrode 5. $k_n$ denotes the thermal conductivity of each of the layers. $w_c$ denotes a current injection width by which the p-side electrode 5 is brought into contact with the p-type semiconductor layer. $L_c$ denotes the current injection length by which the p-side electrode 5 is brought into contact with the p-type semiconductor layer. The structure of the semiconductor laser element includes a current injection free region for restricting the region where the current is injected into the semiconductor layer. Therefore, the current injection width $w_c$ is smaller than the stripe width of the waveguide, and the current injection length $L_c$ of the p-side electrode 5 is smaller than the cavity length of the semiconductor laser element 1.

The inventors of the present invention carried out some experiments, and, as a result, gained an insight that the degree by which the thermal impedance is affected by the film thickness of the Ti/Pt layer of the p-side electrode is much more than a calculated value. Specifically, the inventors found that, when the thermal impedance $R_T$ (K/W•m²) per unit surface area of the part of the p-side electrode that is brought into contact with the p-type semiconductor layer, specifically, per unit surface area of the Ti layer of the Ti/Pt laminated film is equal to or less than $1.2 \times 10^4$ K/W•m², it is possible to improve the wall plug efficiency (WPE) of the semiconductor laser element including the p-side electrode. The present invention was invented based on the diligent development efforts described above.

(Semiconductor Laser Element)

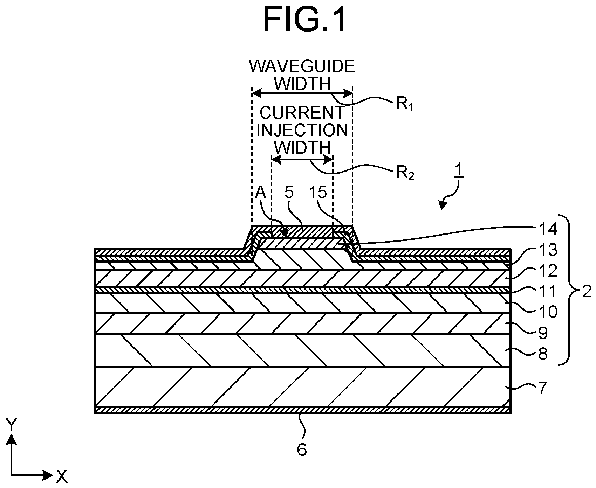

A semiconductor laser element having an electrode according to one embodiment of the present invention, which is based on the diligent development efforts made by the inventors of the present invention, will now be explained. FIG. 1 is a cross-sectional view schematically illustrating a structure of the semiconductor laser element according to this embodiment. In FIG. 1, the width direction is a horizontal direction perpendicular to the direction in which the light is output, and is the X-axis direction in FIG. 1. The Y-axis direction in FIG. 1 is a layer direction of the semiconductor layer in a semiconductor laser element 1.

For example, the semiconductor laser element 1 configured to output a laser beam is a high power semiconductor laser element that includes a waveguide having a wide stripe width equal to or more than 100 μm, that uses a horizontal transverse multi-mode as the waveguide mode, and that uses a continuous-wave operation as a driving method, for example. The high power herein means an output of 3W to 20W or so as output of the semiconductor laser element 1, for example, and an output of several ten W to 200W or so as output of a semiconductor laser device, for example (both being at the room temperature, and continuous-wave (CW) driven). Even if the semiconductor laser element 1 uses a pulse operation as the driving method, the laser beam output from the semiconductor laser element 1 is a pulse laser beam having a pulse width in the order of microseconds or greater.

As illustrated in FIG. 1, the semiconductor laser element 1 has a current injection region $R_2$ formed on a waveguide region $R_1$. The current injection region $R_2$ is a region to which the electrode according to the one embodiment of the present invention is mounted, and through which a current is injected into the waveguide region $R_1$. The semiconductor laser element 1 is a semiconductor laser element having a ridge structure, for example. In the horizontal direction of the laser device having the ridge structure, the X-direction width of the ridge structure provided immediately below an opening A corresponds to the width of the waveguide region (the waveguide width (stripe width) in FIG. 1), and the X-direction width of the opening A corresponds to the horizontal-direction width of the current injection region (the current injection width in FIG. 1).

In other words, the semiconductor laser element 1 according to the embodiment includes the p-side electrode 5 that is an upper electrode, an n-side electrode 6 that is a lower electrode provided on the bottom surface, a substrate 7 including n-type GaAs, a semiconductor laminate 2 formed on the substrate 7, and a passivation film 15. The semiconductor laminate 2 includes an n-type buffer layer 8, an n-type cladding layer 9, an n-type guide layer 10, an active layer 11, a p-type guide layer 12, a p-type cladding layer 13, and a p-type contact layer 14 that are sequentially formed on the substrate 7.

The n-type buffer layer 8 includes GaAs, and is a buffer layer for growing a laminate structure of high-quality epitaxial layers on the substrate 7. The n-type cladding layer 9 and the n-type guide layer 10 include AlGaAs with refractive indices and thicknesses defined to achieve a desirable optical confinement in the layer direction. The Al composition of the n-type guide layer 10 is, for example, equal to or more than 15% and less than 40%. The refractive index of the n-type cladding layer 9 is smaller than that of the n-type guide layer 10. The thickness of the n-type guide layer 10 is preferably equal to or more than 50 nm, and is 1000 nm or so, for example. The thickness of the n-type cladding layer 9 is preferably 1 $\mu$m to 3 $\mu$m or so. These n-type semiconductor layers contain silicon (Si), for example, as an n-type dopant.

The active layer 11 includes a lower barrier layer, a quantum well layer, and an upper barrier layer, and has a single quantum well (SQW) structure. The lower barrier layer and the upper barrier layer have a function as a barrier for confining carriers into the quantum well layer, and include ultra-pure AlGaAs, which is not doped intentionally. The quantum well layer includes ultra-pure InGaAs, which is not doped intentionally. The In composition and the film thickness of the quantum well layer, and the composition of the lower barrier layer and the upper barrier layer are defined depending on a desired light-emission center wavelength (e.g., 900 nm to 1080 nm). The structure of the active layer 11 may be a multiple quantum well (MQW) structure that includes a desired number of repetitions of a laminate structure including a quantum well layer and barrier layers formed on top of and on the bottom of the quantum well layer, or a single quantum well structure. In the active layer 11 described above, a structure with ultra-pure layers, which is not doped intentionally, is used in the explanation, but there are also cases in which a donor or an acceptor is intentionally added to the quantum well layer, the lower barrier layer, and the upper barrier layer.

The p-type guide layer 12 and the p-type cladding layer 13 are paired with the n-type cladding layer 9 and the n-type guide layer 10, respectively, and include AlGaAs having refractive indices and thicknesses defined to achieve a desired optical confinement in the layer direction. The light of the semiconductor laser element 1 mainly resides in a region across the n-type guide layer 10, the active layer 11, and the p-type guide layer 12 in the Y-axis direction, which is the layer direction. These n-type guide layer 10, active layer 11, and p-type guide layer 12 are sometimes referred to as a waveguide layer.

The Al composition of the p-type guide layer 12 is equal to or more than 15% and less than 40%, for example. The refractive index of the p-type cladding layer 13 is smaller than that of the p-type guide layer 12. The Al composition of the p-type cladding layer 13 is defined slightly greater than that of the n-type cladding layer 9 to reduce the waveguide loss by shifting the light field inside the layers, in a direction toward the n-type cladding layer 9. The Al composition of the p-type guide layer 12 is defined smaller than the Al composition of the p-type cladding layer 13. The thickness of the p-type guide layer 12 is equal to or more than 50 nm, and is preferably 1000 nm or so, for example. The thickness of the p-type cladding layer 13 is preferably 1 $\mu$m to 3 $\mu$m or so. These p-type semiconductor layers also contain carbon (C) as a p-type dopant. The C concentration of the p-type guide layer 12 is defined to 0.1 to $1.0 \times 10^{17}$ cm$^{-3}$, and is preferably 0.5 to $1.0 \times 10^{17}$ cm$^{-3}$, for example. The C concentration of the p-type cladding layer 13 is defined equal to or more than $1.0 \times 10^{17}$ cm$^{-3}$, for example. As the p-type dopant, a group II element such as zinc (Zn), magnesium (Mg), cadmium (Cd), and beryllium (Be) may also be used.

The p-type contact layer 14 serving as a p-type semiconductor layer includes a group III-V compound semiconductor layer, specifically, a GaAs layer that is, for example, doped with Zn or C at a concentration higher than $1 \times 10^{19}$ cm$^{-3}$, for example. The passivation film 15 is an insulating film including SiN$_x$, for example, and has the opening A. In the semiconductor laser element 1 having a ridge structure, the ridge structure for confining the laser beam in the X-axis direction is provided to at least a part of the p-type cladding layer 13 immediately below the opening A.

The p-side electrode 5 according to the embodiment is provided on the passivation film 15 in a manner covering the opening A. The p-side electrode 5 is electrically connected to the p-type contact layer 14 via the opening A. The p-side electrode 5 has a Ti/Pt layer having a layered structure in which a titanium (Ti) layer and a platinum (Pt) layer are sequentially laid, on the surface of the p-type contact layer 14. The Ti layer of the p-side electrode 5 has relatively low reactivity with the GaAs that is included in the p-type contact layer 14, so the Ti layer forms a low ohmic contact with the p-type contact layer 14 via an interface reaction layer. Furthermore, because Pt goes through a strong alloy reaction with GaAs, the Ti layer functions as a barrier metal for the Pt layer. In this embodiment, the p-side electrode 5 includes a Ti/Pt/Au layer, in which the gold (Au) layer is laid on top of the Ti/Pt layers. As indicated in Table 1, because Au has high thermal conductivity and low electrical resistivity, Au is preferable as a material for an electrode of the semiconductor device. By contrast, because diffusions of Au into the semiconductor layer cause a deterioration of the reliability of the semiconductor device, the Pt layer is formed as a barrier metal as a layer underneath.

The n-side electrode 6 is configured as an electrode including a material such as a AuGeNi-based material containing germanium (Ge), as described above. In order to reduce the resistance of the ohmic contact between the n-side electrode 6 and the substrate 7 that is an n-type GaAs substrate, the thermal treatment at a temperature between 300 degrees Celsius and 450 degrees Celsius is applied in the fabrication process of the semiconductor laser element 1. The p-side electrode 5 is formed by vacuum deposition or sputtering, for example, and the thermal treatment at a temperature between 300 degrees Celsius and 450 degrees Celsius is then applied subsequently to the formation of the p-side electrode 5. However, even with the thermal treatment, the Ti layer of the p-side electrode 5 reacts extremely poorly with the p-type contact layer 14. Therefore, in order to reduce the resistance of the ohmic contact, the concentration of the p-type impurity with which the p-type contact layer 14 is doped is preferably higher than $1 \times 10^{19}$ cm$^{-3}$, as described above.

In the invention, in the contact portion where the p-side electrode 5 is brought into contact with the surface of the p-type contact layer 14 via the opening A, the thermal impedance is equal to or lower than $1.2 \times 10^4$ K/W•m$^2$. As a method for allowing this thermal impedance to be equal to or lower than $1.2 \times 10^4$ K/W•m$^2$, the film thickness of the Ti layer included in the p-side electrode 5 is equal to or smaller than 35 nm. In this manner, the thermal impedance of the p-side electrode 5 can be reduced to a desired thermal impedance. The film thickness of the Ti/Pt layer is more preferably equal to or smaller than 70 nm. Furthermore, to enable the Ti layer to function as a barrier metal for the Pt layer, which is the layer on top, the film thickness of the Ti layer is equal to or more than 5 nm and equal to or smaller than 35 nm.

As a result of the thermal treatment applied to the n-side electrode 6, a thin interface reaction layer (not illustrated) is sometimes formed on the interface between the p-type contact layer 14 including GaAs and the Ti layer that is the first layer of the p-side electrode 5. In such a case, the film thickness of the Ti layer is defined as a total film thickness of the Ti layer and the Ti-containing interface reaction layer included in the GaAs layer constituting the p-type contact layer 14. The film thicknesses of the Ti layer and the Pt layer can be measured by checking a cross section using the combination of a scanning transmission electron microscope (STEM) and energy dispersive x-ray spectrometry (EDS), and analyzing the film thicknesses and the constituent elements. Specifically, to begin with, line profiles of Ga, Ti, Pt, and Au that are the constituent elements of the p-side electrode 5 and the p-type contact layer 14 in the film-forming direction are measured using the STEM-EDS method. Each of the line profiles is then standardized with the maximum EDS intensity, and the line profiles corresponding to the respective constituent elements and having their EDS intensities standardized are then superimposed over one another. The distance between an intersection of the line profiles of Ga and Ti and an intersection of the line profiles of Ti and Pt is then defined as the film thickness of the Ti layer. The distance between the intersection of the line profiles of Ti and Pt and an intersection of the line profiles of Pt and Au is then defined as the film thickness of the Pt layer.

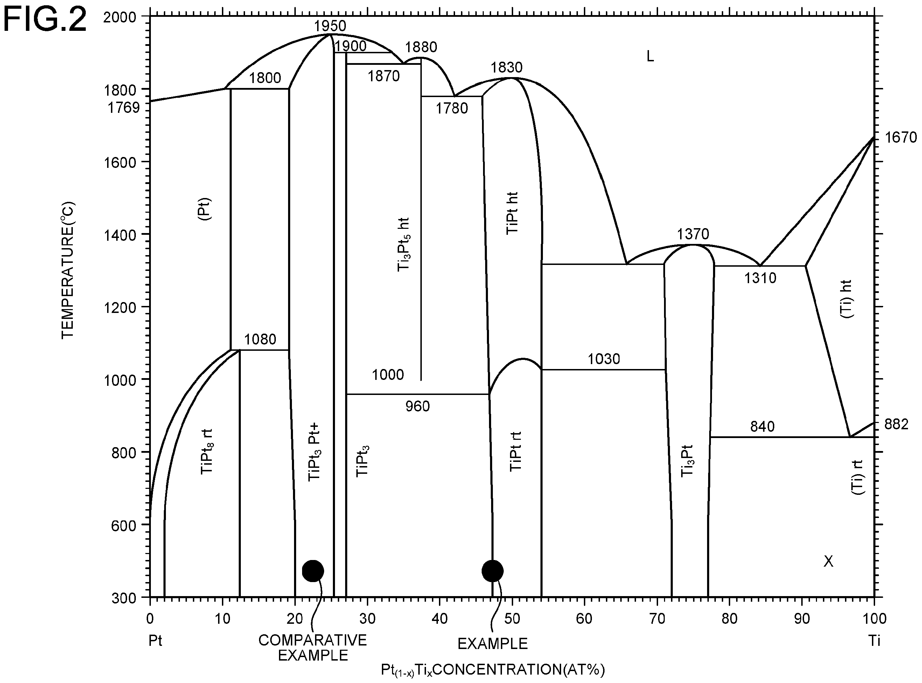

Because the thermal treatment at a temperature between 300 degrees Celsius and 450 degrees Celsius is applied in the fabrication process of the semiconductor laser element, as mentioned earlier, the interface between the Ti layer and the Pt layer in the p-side electrode 5 becomes alloyed. Generally, when a compound is formed with a single pure metal element, the thermal conductivity decreases, and the electrical resistivity increases. For example, the thermal conductivity of TiPt$_3$, which is alloyed Ti and Pt, is approximately 15 W/m•K, and is lower than 21.9 W/m•K that is the thermal conductivity of sole pure Ti. FIG. 2 is a Pt-Ti phase diagram illustrating the phase of Pt and Ti alloy formation. As illustrated in FIG. 2, although the reactivity is low in a thermal treatment at a relatively low temperature that is equal to or lower than 600 degrees Celsius, the intermetallic compounds such as TiPt$_3$, TiPt$_3$, Ti$_3$Pt, and α-TiPt may be formed. In particular, formations of the intermetallic compounds TiPt$_8$, TiPt$_3$, and Ti$_3$Pt need to be avoided because their bonding structures are complex. Hence, based on the Pt-Ti phase diagram illustrated in FIG. 2, the Pt content is preferably 47% to 54% with respect to the Ti content. At the same time, the volume per 1 mol of Ti is 10.64 cm$^3$/mol and the volume per 1 mol of Pt is 9.09 cm$^3$/mol. Therefore, the film thickness of the Ti layer of the p-side electrode 5 is preferably equal to or more than 0.7 times and equal to or less than 1 time the film thickness of the Pt layer.

(Chip-on-Submount)

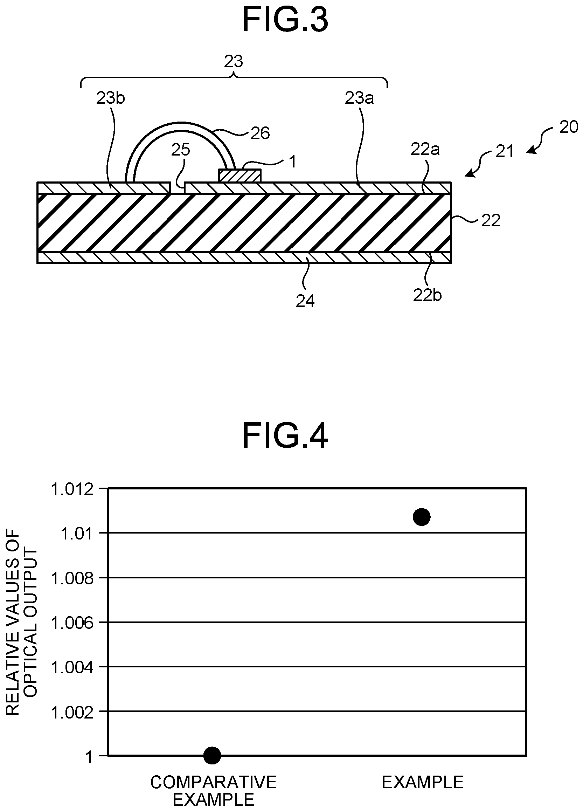

A chip-on-submount according to one embodiment will now be explained. FIG. 3 is a cross-sectional view illustrating the chip-on-submount according to the one embodiment. As illustrated in FIG. 3, this chip-on-submount 20 is a semiconductor-device-mounted submount including the submount 21 and the semiconductor laser element 1 implemented on the submount 21.

The submount 21 serving as a mount includes a substrate 22, a first cover layer 23, and a second cover layer 24. The substrate 22 may contain at least one of aluminum nitride (AlN), alumina ($Al_2O_3$), beryllia (BeO), boron nitride (BN), diamond, silicon carbide (SiC), silicon nitride ($Si_3N_4$), silicon dioxide ($SiO_2$), and zirconia ($ZrO_2$), for example. In this embodiment, the substrate 22 includes AlN, for example. The thickness of the substrate 22 is 0.3 mm to 1.0 mm or so, for example.

The first cover layer 23 has a thickness within a range of 20 $\mu$m to 200 $\mu$m, and is formed on a first surface 22a of the substrate 22. In this embodiment, the first surface 22a is a surface on which the semiconductor laser element 1 is implemented. The first cover layer 23 includes a cover layer 23a and a cover layer 23b. Both of the cover layer 23a and the cover layer 23b are formed as a metallic multilayer film including Cu as the main component, for example. The cover layer 23a and the cover layer 23b are separated by a groove 25. The groove 25 is provided in order to electrically insulate the cover layer 23a from the cover layer 23b.

The semiconductor laser element 1 is joined to and implemented on the submount 21 via the cover layer 23a, with AuSn soldering. On the surface of the cover layer 23a, a precoat (not illustrated) including AuSn is applied. This precoat aids the joining and the implementation of the semiconductor laser element 1 onto the cover layer 23a with the AuSn soldering. In this embodiment, the semiconductor laser element 1 is fixed, with respect to the submount 21, with the p-side electrode 5 facing the side of the submount 21 and with the n-side electrode 6 including the substrate 7 facing the opposite side of the submount 21, that is, in a junction-down configuration with the active layer 11 positioned nearer to the side of the submount 21. With this configuration, the heat generated in the active layer 11 of the semiconductor laser element 1 can be released more easily through the submount 21. The cover layer 23b is electrically connected to the n-side electrode 6 on the top surface of the semiconductor laser element 1, with a bonding wire 26. In the manner described above, the semiconductor laser element 1 is able to receive a power supply from the external via the cover layer 23b, the bonding wire 26, the n-side electrode 6, the p-side electrode 5, and the cover layer 23a.

The second cover layer 24 has a thickness that is within a range between 20 $\mu$m and 200 $\mu$m and that is the same as the thickness of the first cover layer 23, and is formed on a second surface 22b of the substrate 22. The second surface 22b is a surface positioned on the opposite side of the first surface 22a. The second cover layer 24 includes a metallic multilayer film containing Cu as a main component, which is the same as the first cover layer 23.

(Example and Comparative Example)

A p-side electrode 5 according to an example of the one embodiment described above, and another p-side electrode 5 according to a comparative example will now be explained. The semiconductor laser element 1 in the comparative example has the same structure as that illustrated in FIG. 1, but the film thicknesses of the Ti/Pt/Au layers are those used in a conventional technology. The electrode structure, the electrode thickness, the calculated thermal impedance $R_T$, the thermal impedance per unit area $R_T/S$, and the thermal impedance $R_{T,LD}$ of the entire semiconductor laser element 1 corresponding to each of the p-side electrodes 5 according to the example and the comparative example are indicated in Table 2. As indicated in Table 2, the p-side electrode 5 according to the example has a Ti layer with a film thickness of 30 nm, a Pt layer with a film thickness of 30 nm, and an Au layer with a film thickness of 100 nm. By contrast, the electrode according to the comparative example has a Ti layer with a film thickness of 45 nm, a Pt layer with a film thickness of 100 nm, and an Au layer with a film thickness of 100 nm. The area used as a reference for the thermal impedance per unit area $R_T/S$ is the area of the portion where the p-side electrode 5 and the p-type contact layer 14 are in contact with each other, that is, the area of the opening A, and is expressed as a product of the current injection width $w_c$ and the current injection length $L_c$. The thermal impedance $R_{T,LD}$ of the entire semiconductor laser element 1 is a value derived from bias current-bias voltage (I-V) characteristics, bias current-laser optical power (I-L) characteristics, and a current dependency of the emission wavelength, in the condition of the chip-on-submount 20.

Table 2

|  | p-side Electrode Laminate Structure | Electrode Thickness (nm) | $R_T$ ($10^{-3}$ K/W) | $R_T/S$ ($10^4$ K/W·$m^2$) | $R_{T,LD}$ (K/W) |
|---|---|---|---|---|---|
| Example | Ti/Pt/Au 30/30/100 nm | 160 | 4 | 1.2 | 3.17 |
| Comparative Example | Ti/Pt/Au 45/100/100 nm | 245 | 8 | 2.1 | 3.49 |

From Table 2, it can be seen that the thermal impedance $R_T$ in the example has been reduced to $4 \times 10^{-3}$ K/W that is a half the thermal impedance $R_T$ that is $8 \times 10^{-3}$ K/W in the comparative example. Based on this, it can be seen that the thermal impedance per unit area $R_T/S$ is $1.2 \times 10^4$ K/W·$m^2$. The thermal impedance $R_{T,LD}$ of the entire semiconductor laser element 1 in the example is less than that of the comparative example by 0.32 K/W. In other words, the thermal impedance $R_T$ of the p-side electrode 5 according to the example has been reduced in the order of $10^{-3}$ K/W (= mK/W), e.g., 0.004 K/W or so, compared with that in the comparative example. By contrast, the thermal impedance $R_{T,LD}$) of the entire semiconductor laser element 1 has been reduced in the order of $10^{-1}$ K/W (100 mK/W), e.g., 0.32 K/W or so. Therefore, it can be seen that the thermal impedance $R_{T,LD}$ of the entire semiconductor laser elements 1 is reduced by two orders of magnitude or so compared with that in the thermal impedance $R_T$ of the p-side electrode 5. In other words, it can be seen that, by reducing the thickness of the Ti layer and the Pt layer of the p-side electrode 5 in such a manner that the thermal impedance per unit area becomes equal to or smaller than $1.2 \times 10^4$ K/W•m$^2$, the thermal impedance in the actual semiconductor laser element 1 is improved by approximately 80 times the calculated thermal impedance. This is because, by suppressing the formation of the interface reaction layer or the intermetallic compounds during the process of the thermal treatment performed subsequently to the formation of the p-side electrode 5, the thermal impedance is improved more than the calculated value, and the forward voltage is reduced.

It has been confirmed that, even if the Ti layer that was the first layer of the layered structure constituting the p-side electrode 5 was reduced in thickness from conventional 45 nm to 30 nm, the adhesiveness remained about the same in the example as well as in the comparative example, and the p-side electrode 5 did not peel off when the resist was lifted off in the process of forming the electrode pattern for the p-side electrode 5. Furthermore, with the thickness of Ti layer reduced, even when the Pt layer that was the second layer was reduced in thickness from 100 nm in the comparative example to 30 nm in the example, no difference in the reliability between the example and the comparative examples was observed in aging tests. At this time, the line profiles of Ga, As, Ti, Pt, and Au that were the constituent elements were measured using the STEM-EDS method. A thin interface reaction layer including a mixture of Ga, As, and Ti and having a film thickness of 5 nm or so was observed between the GaAs layer that was the p-type contact layer, and the Ti layer. Therefore, the film thickness of the Ti layer that is the first layer is equal to or more than 5 nm, and equal to or smaller than 35 nm considering the effect of the WPE improvement resultant of the improvement in the thermal impedance, and variations of 5 nm or so in the film thickness of the Ti layer that is the first layer at the time of the film formation of the Ti layer.

Furthermore, gradual diffusions of Au into the Pt layer that is the second layer were observed in the interface between the Ti layer and the Pt layer. Therefore, if the film thickness of the Pt layer that is the second layer is smaller than 30 nm, the Pt layer does not serve the function of the barrier metal for the Au layer. Based on this, the film thickness of the Pt layer that is the second layer is equal to or more than 30 nm. Furthermore, from the viewpoint of the thermal impedance, it becomes more preferable as the film thicknesses of the Ti layer that is the first layer and the Pt layer that is the second layer becomes smaller.

However, considering variations of the film thickness of 5 nm or so at the time of film formation of the Pt layer, the film thickness of the Pt layer that is the second layer is preferably within the range equal to or more than 30 nm and equal to or smaller than 35 nm. Therefore, considering the points described above, the sum of the film thicknesses of the Ti layer that is the first layer and of the Pt layer that is the second layer is preferably equal to or smaller than 70 nm. From the viewpoint of the thermal impedance and the electrical resistance, because the performance of the Au layer that is the third layer is better than those of the other metals, Au is the most preferred electrode material for a high power semiconductor laser element. However, the material of the third layer is not limited to Au, but a multilayer metal laminate structure may also be used.

FIGS. 4, 5, and 6 are graphs illustrating relative values of optical power, relative values of forward voltage, and relative values of WPE, respectively, in the semiconductor laser elements 1 according to one example of the one embodiment and the comparative example using a conventional technology. In FIGS. 4 to 6, the relative values according to the one example are relative values of standardizations assuming that each of the optical power, the forward voltage, and the WPE of the semiconductor laser element 1 according to the comparative example using the conventional technology is one.

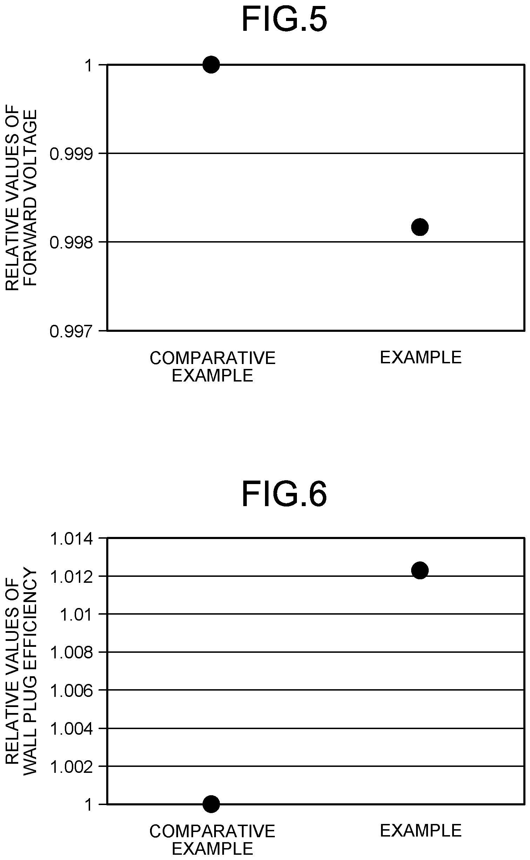

It can be seen that, from FIG. 4, the optical power of the semiconductor laser element in the example was improved by approximately 1.1%, compared with that in the comparative example. It can be considered that this improvement was achieved because the junction temperature was reduced due to a reduction in the thermal impedance of the p-side electrode 5. It can be seen that, from FIG. 5, the forward voltage of the semiconductor laser element in the example decreased by approximately 0.2%, compared with that in the comparative example. Considering that the same electrode material was used for the p-side electrode 5 in the example and that in the comparative example, it can be considered that this reduction was achieved because the electrical resistance decreased due to the reduction in the thickness of the p-side electrode 5, and also because the formations of the interface reaction layer and the intermetallic compounds were suppressed. It can be seen that, from FIG. 6, the WPE of the semiconductor laser element in the example increased by approximately 1.2%, compared with that in the comparative example. It can be considered this increase was achieved because of the reduction in the forward voltage as well as the increase in the optical power. Based on these results, it can be seen that the junction temperature can be reduced, the optical power can be increased, and the WPE can be improved by reducing the thermal impedance of the p-side electrode 5.

According to the one embodiment of the present invention explained above, it is possible to improve the WPE of a semiconductor laser element 1 with the thickness of the Ti/Pt layers of the p-side electrode 5 that is the p-side electrode of the semiconductor laser element being thinner than the conventional counterpart, and the thermal impedance per unit area being equal to or lower than $1.2 \times 10^4$ K/W•m².

One embodiment of the present invention has been specifically explained above, but the present invention is not limited to the one embodiment described above, and various modifications that are based on the technical idea of the present invention are still possible. For example, the numbers and the structure of the semiconductor laser element described in the one embodiment are merely exemplary, and different numbers and structure may also be used, as required. For example, it is possible to use an InP-based or GaN-based semiconductor laser element, as the semiconductor laser element. The invention is however only as defined in the appended claims.

Industrial Usability

The present invention can be preferably used in a laser device for industrial use having high output power and high efficiency.

Reference Signs

1: Semiconductor laser element
2: Semiconductor laminate
5: P-side electrode
6: N-side electrode
7: Substrate
8: N-type buffer layer
9: N-type cladding layer
10: N-type guide layer
11: Active layer
12: P-type guide layer
13: P-type cladding layer
14: P-type contact layer
15: Passivation film
20: Chip-on-submount
21: Submount
22: Substrate
22a: First surface
22b: Second surface
23: First cover layer
23a, 23b: Cover layer
24: Second cover layer
25: Groove
26: Bonding wire

## Claims

1. An electrode (5) comprising a Ti layer and a Pt layer that are sequentially laid on a surface of a p-type semiconductor layer (12, 13, 14), wherein

   a thermal impedance per unit area of a contact portion that is in contact with the surface of the p-type semiconductor layer (12, 13, 14) is equal to or smaller than $1.2 \times 10^4$ K/W•m²,
   **characterised in that** a film thickness of the Ti layer is equal to or more than 5 nm and equal to or smaller than 35 nm, and a film thickness of the Pt layer is equal to or more than 30 nm.

2. The electrode (5) according to claim 1, wherein a sum of a film thickness of the Ti layer and a film thickness of the Pt layer is equal to or smaller than 70 nm.

3. The electrode (5) according to any one of claims 1 to 2, wherein a film thickness of the Pt layer is equal to or more than 0.7 times and equal to or smaller than 1 time a film thickness of the Ti layer.

4. The electrode (5) according to any one of claims 1 to 3, wherein an Au layer is further laid on top of the Pt layer.

5. A semiconductor laser element (1) comprising an n-type semiconductor layer (8, 9, 10), an active layer (11), and a p-type semiconductor layer (12, 13, 14) that are sequentially laid on top of another, the semiconductor laser element being able to output a laser beam, wherein the electrode according to any one of claims 1 to 4 is provided on a surface of the p-type semiconductor layer (12, 13, 14).

6. The semiconductor laser element (1) according to claim 5, wherein the p-type semiconductor layer (12, 13, 14) is a group III-V compound semiconductor layer.

7. The semiconductor laser element (1) according to claim 5 or 6, wherein the p-type semiconductor layer (12, 13, 14) is a GaAs layer.

8. The semiconductor laser element (1) according to any one of claims 5 to 7, wherein a concentration of a p-type impurity in the p-type semiconductor layer (12, 13, 14) is equal to or higher than $1 \times 10^{19}$ cm$^{-3}$.

9. The semiconductor laser element (1) according to any one of claims 5 to 8, wherein a driving method used for the semiconductor laser element is a continuous-wave operation.

10. The semiconductor laser element (1) according to any one of claims 5 to 9, wherein a stripe width is equal to or greater than 100 $\mu$m.

11. A chip-on-submount (20) comprising:

the semiconductor laser element (1) according to any one of claims 5 to 10; and
a mount (21) on which the semiconductor laser element (1) is fixed in a junction-down configuration.

**Patentansprüche**

1. Elektrode (5), die aufweist, eine Ti-Schicht und eine Pt-Schicht, die aufeinanderfolgend auf eine Oberfläche einer Halbleiterschicht (12, 13, 14) vom p-Typ gelegt worden sind, wobei

eine thermische Impedanz pro Flächeneinheit von einem Kontaktabschnitt, der in Kontakt zu der Oberfläche von der Halbleiterschicht (12, 13, 14) p-Typ ist, gleich oder kleiner als $1,2 \times 10^4$ K/W $\cdot$ m$^2$ ist,
**dadurch gekennzeichnet, dass** eine Filmdicke von der Ti-Schicht gleich oder größer als 5 nm und gleich oder kleiner als 35 nm ist,
und eine Filmdicke von der Pt-Schicht ist gleich oder größer als 30 nm.

2. Elektrode (5) nach Anspruch 1, wobei eine Summe einer Filmdicke der Ti-Schicht und einer Filmdicke der Pt-Schicht gleich oder kleiner als 70 nm ist.

3. Elektrode (5) gemäß irgendeinem der Ansprüche 1 bis 2, wobei eine Filmdicke von der Pt-Schicht gleich oder größer als das 0,7 x und gleich oder kleiner als das 1 x eine Filmdicke von der Ti-Schicht ist.

4. Elektrode (5) gemäß irgendeinem der Ansprüche 1 bis 3, wobei eine Au-Schicht ferner auf die Oberfläche von der Pt-Schicht gelegt ist.

5. Halbleiterlaserelement (1), das eine Halbleiterschicht (8, 9, 10) vom n-Typ, eine aktive Schicht (11) und eine Halbleiterschicht (12, 13, 14) vom p-Typ aufweist, die aufeinanderfolgend aufeinander gelegt sind, wobei das Halbleiterlaserelement dazu in der Lage ist, einen Laserstrahl auszugeben, wobei die Elektrode gemäß irgendeinem der Ansprüche 1 bis 4 auf einer Oberfläche der Halbleiterschicht (12, 13, 14) vom p-Typ zur Verfügung gestellt ist.

6. Halbleiterlaserelement (1) gemäß Anspruch 5, wobei die Halbleiterschicht (12, 13, 14) vom p-Typ eine zusammengesetzte Halbleiterschicht der III-V-Gruppe ist.

7. Halbleiterlaserelement (1) gemäß Anspruch 5 oder 6, wobei die Halbleiterschicht (12, 13, 14) vom p-Typ eine GaAs-Schicht ist.

8. Halbleiterlaserelement (1) gemäß irgendeinem der Ansprüche 5 bis 7, wobei eine Konzentration einer Verunreinigung vom p-Typ in der Halbleiterschicht (12, 13, 14) vom p-Typ gleich oder größer als $1 \times 10^{19}$ cm$^{-3}$ ist.

9. Halbleiterlaserelement (1) gemäß irgendeinem der Ansprüche 5 bis 8, wobei ein Betriebsverfahren, das für das Halbleiterlaserelement verwendet wird, ein Betrieb mit kontinuierlicher Welle ist.

10. Halbleiterlaserelement (1) gemäß irgendeinem der Ansprüche 5 bis 9, wobei eine Streifenbreite gleich zu oder größer als 100$\mu$m ist.

11. Chip auf unterer Halterung (20), was aufweist

   ein Halbleiterlaserelement (1) gemäß irgendeinem der Ansprüche 5 bis 10: und
   einen Aufbau (21), auf welchem das Halbleiterlaserelement (1) in einer Konfiguration mit dem Junction bzw. der Verbindung nach unten festgelegt ist.


**Revendications**

1. Électrode (5) comprenant une couche de Ti et une couche de Pt qui sont posées séquentiellement sur une surface d'une couche semi-conductrice de type p (12, 13, 14), et dans laquelle

   l'impédance thermique par unité de surface d'une portion de contact qui est en contact avec la surface de la couche semi-conductrice de type p (12, 13, 14) est inférieure ou égale à $1,2 \times 10^4$ K/W•m$^2$,
   **caractérisée en ce que** l'épaisseur de film de la couche de Ti est supérieure ou égale à 5 nm et inférieure ou égale à 35 nm, et l'épaisseur de film de la couche de Pt est supérieure ou égale à 30 nm.

2. Électrode (5) selon la revendication 1, dans laquelle le total de l'épaisseur de film de la couche de Ti et de l'épaisseur de film de la couche de Pt est inférieur ou égal à 70 nm.

3. Électrode (5) selon l'une quelconque des revendications 1 ou 2, dans laquelle l'épaisseur de film de la couche de Pt est supérieure ou égale à 0,7 fois et inférieure ou égale à 1 fois l'épaisseur de film de la couche de Ti.

4. Électrode (5) selon l'une quelconque des revendications 1 à 3, dans laquelle une couche d'Au est en outre posée sur la couche de Pt.

5. Élément laser à semi-conducteur (1) comprenant une couche semi-conductrice de type n (8, 9, 10), une couche active (11) et une couche semi-conductrice de type p (12, 13, 14) qui sont superposées de manière séquentielle, l'élément laser à semi-conducteur étant capable de produire un faisceau laser, ladite électrode selon l'une quelconque des revendications 1 à 4 étant prévue sur une surface de la couche semi-conductrice de type p (12, 13, 14).

6. Élément laser à semi-conducteur (1) selon la revendication 5, dans lequel la couche semi-conductrice de type p (12, 13, 14) est une couche semi-conductrice à base de composé III-V.

7. Élément laser à semi-conducteur (1) selon la revendication 5 ou 6, dans lequel la couche semi-conductrice de type p (12, 13, 14) est une couche de GaAs.

8. Élément laser à semi-conducteur (1) selon l'une quelconque des revendications 5 à 7, dans lequel la concentration d'une impureté de type p dans la couche semi-conductrice de type p (12, 13, 14) est supérieure ou égale à $1 \times 10^{19}$ cm$^{-3}$.

9. Élément laser à semi-conducteur (1) selon l'une quelconque des revendications 5 à 8, dans lequel le procédé de pilotage utilisé pour l'élément laser à semi-conducteur est une opération à ondes continues.

10. Élément laser à semi-conducteur (1) selon l'une quelconque des revendications 5 à 9, dans lequel la largeur de bande est supérieure ou égale à 100 $\mu$m.

**11.** Puce sur embase (20) comprenant :

l'élément laser à semi-conducteur (1) selon l'une quelconque des revendications 5 à 10, et
un support (21) sur lequel l'élément laser à semi-conducteur (1) est fixé dans une configuration de jonction vers le bas.

# FIG.1

FIG.2

# FIG.3

# FIG.4

## FIG.5

## FIG.6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 3314616 B
- JP 2006156639 B
- US 2013156060 A
- EP 3872939 A